# EUROPEAN PATENT APPLICATION

(11) **EP 2 292 424 A1**
(43) Date of publication of application: **09.03.2011**
(21) Application number: 09766598.8
(22) Date of filing: 12.06.2009
(51) Int. Cl.: B32B 9/00, B32B 15/09, B32B 27/36

(54) **VAPOR DEPOSITION FILM**

(30) Priority: 16.06.2008 JP 2008156502
(71) Applicant: Toray Industries, Inc., Tokyo 103-8666 (JP); Kureha Corporation, Chuo-ku Tokyo 103-8552 (JP)
(72) Inventor: YAMAMURA Gouhei, Otsu-shi Shiga 520-8558 (JP); SUMI Saori, Otsu-shi Shiga 520-8558 (JP); KIMURA Masahiro, Otsu-shi Shiga 520-8558 (JP); ABE Shunsuke, Tokyo 103-8552 (JP); SATO Takashi, Omitama-shi Ibaraki 311-3436 (JP); SATO Hiroyuki, Iwaki-shi Fukushima 974-8686 (JP); MASUDA Junichi, Otsu-shi Shiga 520-8558 (JP); SHINNUMADATE Hiroshi, Otsu-shi Shiga 520-8558 (JP)
(74) Representative: Oser, Andreas
(86) International application number: PCT/JP2009/060775
(87) International publication number: WO 2009/154150

(57) **Abstract**

Disclosed is a vapor deposition film wherein a vapor deposition layer composed of a metal or an inorganic oxide is formed on at least one side of a resin layer (A) which is composed of a resin composition (1). The resin composition (1) is a polyglycol acid containing not less than 70% by mole of a specific structure (a structure represented by formula (1)) as a repeating unit. The surface on which the vapor deposition layer is deposited has a center line average roughness of 5-50 nm. The vapor deposition film has excellent gas barrier properties, excellent workability and decomposition resistance sufficient for practical use.

## Description

### [Technical field]

The invention relates to a vapor deposited film with high gas barrier properties against oxygen, carbon dioxide gas, and moisture.

### [Background art]

Conventionally, there has been an increasing demand for packaging materials that can block the penetration of gas from outside to prevent the deterioration of contents such as foodstuffs and chemicals, as well as electronic parts in recent years. Recently developed film materials having high gas barrier properties that are suitable for this purpose include films laminated with an ethylene vinyl alcohol copolymer and composite films comprising material with gas barrier properties such as polyamide. Such films as ethylene vinyl alcohol copolymers and polyamide, however, gas barrier properties tend to depend on humidity, and have the problem of suffering large degradation under high humidity.

The gas barrier polymers with little humidity dependence that have been proposed include polyglycolic acid (hereinafter abbreviated as PGA), and the gas barrier films proposed include oriented film of polyglycolic acid etc. (Patent document 1, for instance) and composite films composed of polyglycolic acid laminated with other thermoplastic resin film (Patent document 2, for instance).

On the other hand, vapor deposited films having a metal layer of aluminum etc. are in wide used because their barrier properties do not depend significantly on humidity, and in particular, transparent vapor deposited films with a silicon oxide or aluminum oxide layer are preferred because they provide high visibility to confirm the state of contents.

### [Prior art references]

### [Patent document]

Patent document 1: Japanese Unexamined Patent Publication (Kokai) No. HEI 10 -60136
Patent document 2: Japanese Unexamined Patent Publication (Kokai) No. HEI 10 -80990

### [Summary of the invention]

### [Problems to be solved by the invention]

The films described in the aforementioned Patent documents 1 and 2 use polyglycolic acid as gas barrier polymer with small humidity dependence, but polyglycolic acid is high in degradability and has a high risk of decomposition in an exposed state. With respect to decomposition control, it may be preferable to use a film composed of polyglycolic acid as an inner layer sandwiched between other resin layers to reduce the risk of decomposition, though thin films of such a structure can fail to have sufficient gas barrier properties.
On the other hand, the aforementioned vapor deposited films with an aluminum or other metal layer have been preferred because of smaller humidity dependence of their gas barrier properties and high visibility to confirm the state of contents. In recent years, however, there has been an increasing demand for materials with higher gas barrier properties, and vapor deposited PET films composed of polyethylene terephthalate (hereinafter abbreviated as PET) as raw fabric tend to fail in serving sufficiently though they have been widely used as industrial and packaging materials.
Thus, the object of the invention is to provide a vapor deposited film that has high gas barrier properties, high processing suitability, and sufficient decomposition resistance for practical use.

### [Means of solving the problems]

As a result of intensive studies to solve the aforementioned problem, the inventors has achieved the invention after finding that a vapor deposited film that has high gas barrier properties, high processing suitability, and sufficient decomposition resistance for practical use can be provided by forming a resin layer (A) composed of polyglycolic acid as a vapor deposited surface and controlling its surface profile. Specifically, the invention is as described below.
1) A vapor deposited film comprising at least a resin layer (A) composed of a resin composition (1) wherein a vapor deposited layer of metal or inorganic oxide is provided at least on one side of the resin layer (A), while the resin composition (1) contains a polyglycolic acid component in which a structure as represented by Chemical formula 1 (hereinafter, referred to as Formula (1) in some cases) accounts for 70 mol% or more, and the vapor deposited layer side surface of the resin layer (A) has a center line average roughness of 5 nm to 50 nm.

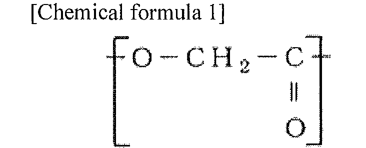

2) A vapor deposited film as specified in Paragraph 1) additionally comprising a resin layer (B) composed of a resin composition (2) wherein the resin composition (2) has a glass transition temperature of 65°C or less.
3) A vapor deposited film as specified in Paragraph 2) comprising a resin layer (B), a resin layer (A), and a vapor deposited layer laminated in this order wherein the resin composition (2) contains at least one selected from the following: aromatic polyester, aliphatic polyester, polyolefin, and copolymers thereof.
4) A vapor deposited film as specified in either Paragraph 2) or 3) wherein the resin composition (2) contains polyethylene terephthalate and polybutylene terephthalate in a polyethylene terephthalate to polybutylene terephthalate ratio by weight of 95/5 to 5/95.
5) A vapor deposited film as specified in any of Paragraphs 1) to 4) that has a heat shrinkage degree of 8 % or less in the length direction and a heat shrinkage degree of 8% or less in the width direction after heat treatment at 150°C for 30 minutes.

### [Effect of the invention]

The vapor deposited film of the invention has high gas barrier properties against oxygen, carbon dioxide gas, moisture, etc., and high processing suitability, and serve preferably as film for general industrial and packaging materials.

### [Best mode for carrying out the invention]

### Desirable embodiments are described and the invention is illustrated in detail below.

The vapor deposited film of the invention comprises at least a resin layer (A) composed of a resin composition (1) wherein a vapor deposited layer of metal or inorganic oxide is provided at least one side of the resin layer (A), while the resin composition (1) contains a polyglycolic acid component in which a structure as represented by said Chemical formula 1 accounts for 70 mol% or more, and the vapor deposited layer side surface of the resin layer (A) has a center line average roughness of 5 nm to 50 nm.

It is important for the vapor deposited film of the invention that the vapor deposited layer side surface (vapor deposited surface) of the resin layer (A) has a center line average roughness of 5 nm to 50 nm. It is preferably 10 to 50 nm, more preferably 15 to 40 nm, and still more preferably 15 to 30 nm. If the vapor deposited layer side surface of the resin layer (A) has a center line average roughness of 5 nm to 50 nm, pinholes will not formed significantly during the deposition process to achieve high barrier properties, and a high processing suitability is maintained during the film production and deposition processes. If the center line average roughness is less than 5 nm, the film will have poor slipping properties, possibly leading to blocking and electrostatic generation during winding-up and deposition in the film production process, or causing deterioration in barrier properties of the deposited layer. If the center line average roughness exceed 50 nm, on the other hand, uniform vapor deposited layer formation will not achieved, leading to a large deterioration in barrier properties.

For the film comprising at least the resin layer (A) composed of the resin composition (1) (hereinafter referred to as base film), there are no particular limitations on the method to be used to cause the vapor deposited layer side surface of the resin layer (A) (vapor deposited surface) to have a center line average roughness of 5 nm to 50 nm. However, the polyglycolic acid has a high crystallization speed, and therefore, it is preferable to use a method to control the decrease in the crystallinity of the resin layer (A), and its orientation under some stretching and heat fixation conditions. In the case of sequential biaxial stretching of a film composed of the resin layer (A), for instance, such control can be achieved if it is biaxially stretched at a stretching temperature of 70°C or less, with a two dimensional stretching ratio of 4.0 or more, followed by heat treatment. Furthermore, polyglycolic acid is low in heat stability, and undesirable matters such as gel can be formed in the molten polymer. Such undesirable matters often form bulky projections to make the surface rough. To remove them, it is preferable that the molten polymer extruded from the extruder is passed through a filter produced by sintering and compression of stainless steel fiber or sintering of stainless steel powder. Film production methods are discussed in detail below. If the vapor deposited film of the invention has a vapor deposited layer, the center line average roughness of the vapor deposited layer side surface of the resin layer (A) (vapor deposited surface) can be checked after removing the vapor deposited layer with an acid.

After heat treatment at 150°C for 30 minutes, the vapor deposited film of the invention preferably has a heat shrinkage degree of 8% or less in the length direction and a heat shrinkage degree of 8% or less in the width direction. It is more preferable that the heat shrinkage degree in the length direction is -1% to 6% while the heat shrinkage degree in the width direction is -2% to 6%, and still more preferably the shrinkage degree is 0% to 4% in the length direction while the heat shrinkage degree is -1% to 5% in the width direction. If both the heat shrinkage degree in length direction and that in the width direction are 8% or less after heat treatment at 150°C for 30 minutes, the heat-resistant dimensional stability will be high, serving to prevent the gas barrier properties from deteriorating as a result of film's structural change under hating during the deposition step. Furthermore, said shrinkage range is preferable in view of processing suitability for printing and bag-making processes as well as printing accuracy. There are no particular limitations on the method to allow the vapor deposited film heat-treated at 150°C for 30 minutes to have a heat shrinkage degree of 8% or less both in the length direction and in the width direction, but a preferable method is to control the temperature and the heat treatment time during the heat fixation step for production of said film comprising at least the resin layer (A).

In order to prevent the resin layer (A), which will form the vapor deposited surface, from suffering a shift of the film surface due to elongation and heat during the deposition step and to depress crack generation due to tension after deposition step, the resin layer (A) according to the invention preferably has a tensile modulus of 3.0 GPa or more both in the length direction and in the width direction. It is more preferably 4.0 to 8.0 GPa, still more preferably 5.0 GPa to 8.0 GPa. If the elastic modulus is less than 3.0 GPa, the gas barrier properties can deteriorate due to film's structural change under heating during the deposition step. There are no particular limitations on the upper limit, but it is commonly 8.0 GPa. The preferable methods to adjust the tensile modulus of the resin layer (A) to 3.0 GPa or more include controlling the orientation in said film comprising at least the resin layer (A) by regulating the stretching temperature and ratio during the stretching step and the heat treatment temperature during the heat fixation step.

The film of the vapor deposited film of the invention is said film comprising at least the resin layer (A) composed of the resin composition (1), but the film may additionally has a resin layer (B) composed of a resin composition (2) (laminated film consisting of the resin layer (A) laminated with the resin layer (B)). To determine the elastic modulus of the resin layer (A) of this case, the tensile modulus of the laminated film consisting of the resin layer (A) laminated with the resin layer (B) and that of the film having only the resin layer (B) that remains after peeling off the resin layer (A) are measured, followed by proportional calculation according to the thickness ratio of the laminated layers. If a vapor deposited layer exists, the tensile modulus can be checked after removing it with acid.

The resin layer (A) preferably has a plane orientation coefficient (hereinafter referred to as fn) of 0.01 to 0.1. This coefficient is determined by the equation (Nx + Ny)/2 -Nz where Nx, Ny, and Nz represent the surface refractive index in the length direction, surface refractive index in the width direction, and refractive index in the thickness direction, respectively. It is more preferably 0.02 to 0.08, still more preferably 0.03 to 0.07. If fn is less than 0.01, the orientation will be very low, possibly leading to deterioration in gas barrier properties, whereas cleavage can take place if it exceeds 0.1. The preferable methods to adjust the fn value of the resin layer (A) to 0.01 to 0.1 include controlling the orientation in said film comprising at least the resin layer (A) by regulating the stretching temperature and stretching ratio during the stretching step and the heat treatment temperature during the heat fixation step. If a vapor deposited layer exists, the plane orientation coefficient can be checked after removing it with acid. In the case of said laminated film consisting of the resin layer (A) laminated with the resin layer (B), the plane orientation coefficient of the resin layer (A) can be checked based on measurement of the surface refractive index of the resin layer (A).

The vapor deposited film of,the invention is produced by forming a vapor deposited layer over at least one side of the resin layer (A) of a film that comprises said resin layer (A) composed of the resin composition (1). The resin composition (1) contains a polyglycolic acid component having the structure represented by the undermentioned Chemical formula 2 (Formula (1)) as a repeating unit which accounts for 70 mol% or more of the total monomer units (100 mol%) that constitute the polyglycolic acid component of the resin composition (1).

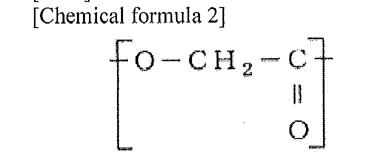

It is necessary that the repeating unit represented by the Formula (1) in the polyglycolic acid component of the resin composition (1) should account for 70 mol% or more of the total monomer units (100 mol%) that constitute the polyglycolic acid component of the resin composition (1). It is preferably 85 mol% or more, more preferably 90 mol% or more, and its upper limit is 100 mol%. The gas barrier properties and heat resistance deteriorate if the repeating unit represented by the Formula (1) in the polyglycolic acid component of the resin composition (1) accounts for only less than 70 mol%. If its content is 70 mol% or more, however, a small amount of another comonomer can be introduced as an additional component to control the crystalizability of the polyglycolic acid, use a lower extrusion temperature, and improve its stretchability, and furthermore, it serves to depress the crystallization in the stretching step, which can make the surface rough as described below. Introduction of a comonomer in the polyglycolic acid is preferable because, described below, it serves to improve the adhesion between the resin layer (A) and the resin layer (B) at the lamination interface when the resin layer (A) composed of the resin composition (1) is laminated with the resin layer (B) composed of the resin composition (2) and also because the extrusion temperature of the resin layer (A) and that of the resin layer (B) can be made closer during the co-extrusion step. Specifically, it is preferable that part of the component contained in the resin composition (2) is used as said small amount of another comonomer to be copolymerized in the polyglycolic acid component of the resin composition (1). If the resin composition (2) is polylactic acid, for instance, lactide or lactic acid may be copolymerized as comonomer up to 5 mol% or more and 30 mol% or less in the polyglycolic acid component of the resin composition (1).

Such copolymerizable components, or comonomers, in the polyglycolic acid include, for instance, cyclic monomers such as ethylene oxalate, lactide, lactones (including β-propiolactone, β-butyrolactone, pivalolactone, γ-butyrolactone, δ-valerolactone, β-methyl-δ-valerolactone, ε-caprolactone), trimethylene carbonate, and 1,3-dioxane; hydroxy carboxylic acids such as lactic acid, 3-hydroxy propane acid, 3-hydroxy butane acid, 4-hydroxy butane acid, and 6-hydroxy caproic acid, and alkyl esters thereof; and virtually equimolar mixtures of an aliphatic diol such as ethylene glycol and 1,4 -butanediol and an aliphatic dicarboxylic acid such as succinic acid and adipic acid, or an alkyl ester thereof. Of these, cyclic compounds such as lactide, caprolactone, and trimethylene carbonate, and hydroxy carboxylic acid such as lactic acid are used preferably because they are easy to copolymerize into copolymers with good physical properties.

A polyglycolic acid can be synthesized through dehydration condensation of a glycolic acid, dealcoholization condensation of an alkyl glycolate, or ring opening polymerization of a glycolide. Of these, a particularly preferable polyglycolic acid synthesis method is to heat a small amount of a glycolide with a catalyst (cationic catalyst such as organic tin carboxylate, halogenated tin, halogenated antimony) from about 120°C up to about 250°C to cause ring opening polymerization. Such ring opening polymerization is preferably performed through bulk polymerization or solution polymerization.

Said polyglycolic acid and polyglycolic acid copolymer resin contained in said resin composition (1) preferably account for 70 wt% or more, more preferably 80 wt% or more, of the total components (100 wt%) of the resin composition (1), and its upper limit is 100 wt%.

The resin composition (1) may contain an inorganic filler, other thermoplastic resins, and plasticizer, in addition to polyglycolic acid, unless they impede the achievement of the object of the invention. The polyglycolic acid component may contain various additives as needed, including thermal stabilizer, photostabilizer, moisture resistant agent, waterproof agent, water repellent agent, lubricant, mold releasing agent, coupling agent, oxygen absorbent, pigment, and dye. They may be added up to any content unless they impede the achievement of the object of the invention, but they preferably account for 30 wt% or less of the total components (100 wt%) of the resin composition (1).

To improve the melting stability of the polyglycolic acid, it is preferable that the resin composition (1) contains a thermal stabilizer such as, for instance, a phosphate comprising a pentaerythritol backbone structure, phosphorus compound composed at least one hydroxyl group and at least one long chain alkyl ester group, heavy metal deactivator, and metal carbonate. These thermal stabilizers may be used singly or in combination of two or more thereof.

The resin composition (1) in the resin layer (A) preferably has a melt viscosity of 1,000 poise to 10,000 poise, more preferably 2,000 poise to 6,000 poise, and still more preferably 2,500 poise to 5,500 poise, (100 sec⁻¹) at 270°C. If the melt viscosity (100 sec⁻¹) at 270°C of the resin composition (1) is less than 1,000 poise, the polyglycolic acid, i.e. the primary component of the resin composition (1), will be too low in molecular weight, possibly suffering decomposition. If the resin composition (1) has a melt viscosity larger than 10,000 poise, it will require a very large load to the extruder in the polymer extrusion step, or a very high filtering pressure, which can cause problems or make it difficult to perform its lamination with the resin layer (B) as described below.

There are no specific limitations on the thickness of the vapor deposited film of the invention, but in view of suitability for deposition, it is preferable that the base film having at least the resin layer (A) composed of at least the resin composition (1), in an undeposited state (i.e. before forming a vapor deposited layer), has a thickness of 5 µm to 200 µm, more preferably 8 to 100 µm, and still more preferably 10 to 50 µm.

Said film comprising at least the resin layer (A) composed of the resin composition (1), which constitutes the vapor deposited film of the invention, may comprise said resin layer (A) laminated with said resin layer (B) composed of the resin composition (2), and in particular, it is preferable that the base film is in the form of a two layer structure consisting of said resin layer (A) composed of the resin composition (1) and said resin layer (B) composed of the resin composition (2) directly adhered to each other. Thus, lamination with a different resin can serve to produce a cost effective film. In this case, the thickness ratio of the resin layer (B) to the base film (a film comprising at least said resin layer (A), and additionally laminated with said resin layer (B)) is preferably 0.98 to 0.1, more preferably 0.95 to 0.3, and still more preferably 0.95 to 0.6, relative to 1.0 accounted for by the entire thickness of the base film. In the case where said film (base film) comprising at least the resin layer (A) is additionally laminated with the resin layer (B), it is preferable that the vapor deposited film consists of the resin layer (B), the resin layer (A), and the vapor deposited layer laminated in this order.

In view of processability for lamination, it is preferable that that the melt viscosity of the resin composition (2) is nearly equal to or slightly larger than that of the resin composition (1) at the extrusion temperature. Uniform lamination will be difficult if the melt viscosity of the resin composition (2) is extremely small. If there is large difference in melt viscosity, it is preferable that they are extruded at different temperatures and laminated at the orifice, or that the viscosity of the resin composition (2) is increased by adding a viscosity improver, crosslinked agent, or chain extension agent.

The resin composition (2) in the resin layer (B) is preferably of such a resin as aromatic polyester, aliphatic polyester, polyolefin, and copolymer thereof, in view of extrusion properties, cost, and handleability, and these should preferably be used as primary component of the resin composition (2). Combination of the resin layer (A) with the resin layer (B) of these resins can achieve such advantages as developing high barrier properties as a result of improved heat resistance and stability over time when using an aromatic polyester as primary component of the resin composition (2), producing a biodegradable barrier film when using an aliphatic polyester as primary component of the resin composition (2), and improving the moisture resistance when using a polyolefin as primary component of the resin composition (2).

The primary component of the resin composition (2) referred to here means the component that accounts for 70 wt% or more and 100 wt% or less of the total components (100 wt%) of the resin composition (2). Thus, if an aromatic polyester is the primary component of the resin composition (2), it means that the aromatic polyester accounts for 70 wt% or more and 100 wt% or less of the total components (100 wt%) of the resin composition (2).

It is preferable that the resin composition (2) has a glass transition temperature of 65°C or less so that the base film can be stretched at a temperature of 70°C or less. There are no particular limitations on the lower limit to the glass transition temperature of the resin composition (2) if the base film can be stretched at a temperature of 70°C or less. Stretching of the base film at a temperature of 70°C or less is advantageous in that it will be possible to adjust crystallinity and orientation of the resin layer (A), allowing the center line average roughness of the vapor deposited layer side surface of the resin layer (A) to be decreased to 5 to 50 nm. The stretching temperature is preferably 30°C or more.

If the primary component of the resin composition (2) is an aromatic polyester and/or aliphatic polyester, the resin composition (2) preferably have a glass transition temperature in the range of 0 to 65°C, more preferably 30 to 65°C, still more preferably 35 to 60°C, and still more preferably 40 to 55°C. The risk of blocking and decreased mechanical strength of the film will be small if the glass transition temperature of the resin composition (2) is adjusted to 0 to 65°C. Insufficient stretching will be less likely to take place when the base film is stretched at a low temperature of 70°C or less. The glass transition temperature referred to here is the midpoint glass transition temperature determined at a heating rate of 20°C/min according to the JIS-K7121 DSC (differential scanning calorimetry) method.

Various polyesters produced through ester bonding of an acid component and a glycol component may be used as the aromatic polyester or the aliphatic polyester in the resin layer (B) composed of the resin composition (2). The useful acid components for this case include, for instance, aromatic dicarboxylic acids such as terephthalic acid, isophthalic acid, phthalic acid, and naphthalene dicarboxylic acid; aliphatic dicarboxylic acids such as adipic acid, azelaic acid, sebacic acid, decane dicarboxylic acid, and dimer acid; alicyclic dicarboxylic acids such as cyclohexane dicarboxylic acid; hydroxycarboxylic acids such as p-oxy benzoic acid; and polyfunctional acid such as trimellitic acid and pyromellitic acid. The useful glycol components, on the other hand, include, for instance, aliphatic diols such as ethylene glycol, diethylene glycol, butanediol, and hexanediol; alicyclic diols such as cyclohexanedimethanol; aromatic glycols such as bisphenol A and bisphenol S; and others such as diethylene glycol and polyalkylene glycol. Furthermore, they may be copolymerized with a polyether such as polyethylene glycol and polytetramethylene glycol. Two or more of these dicarboxylic acid components and glycol components may be used in combination, and two or more of polyesters may be used as a blend. In particular, it is preferable that polyethylene terephthalate, polybutylene terephthalate, polypropylene terephthalate, and polyesters produced bycopolymerizing them with isophthalic acid, sebacic acid, or dimer acid may be used singly or in combination of two or more of them. The highly biodegradable aliphatic polyesters include polylactic acid, poly 3-hydroxy butyrate, poly 3-hydroxy butyrate-3-hydroxy valerate, polycaprolactone, and other aliphatic polyesters produced by reacting an aliphatic diol such as ethylene glycol and 1,4-butanediol with an aliphatic dicarboxylic acid such as succinic acid and adipic acid. It is also preferable to use a copolymer of an aromatic polyester and an aliphatic polyester such as poly-butylene succinate-terephthalate and poly-butylene adipate-terephthalate.

Of these, in view of heat resistance, stability over time, and gas barrier properties, it is preferable to use a blend of polyethylene terephthalate and polybutylene terephthalate as the primary component of the resin composition (2). Thus, the resin composition (2) preferably contains polyethylene terephthalate and polybutylene terephthalate.

As described above, in order to allow the base film to be stretched at a temperature of 70°C or less, the weight ratio between polyethylene terephthalate and polybutylene terephthalate is preferably as follows: polyethylene terephthalate/polybutylene terephthalate = 95/5 to 5/95. A polyethylene terephthalate/polybutylene terephthalate ratio by weight in the range of 95/5 to 5/95 is preferable because it will be possible to stretch the base film at a temperature of 70°C or less, and as a result, control the center line average roughness of the vapor deposited layer side surface of the resin layer (A) in the base film in the range of 5 to 50 nm. The weight ratio between polyethylene terephthalate and polybutylene terephthalate, i.e. polyethylene terephthalate/polybutylene terephthalate, is more preferably in the range of 80/20 to 10/90, still more preferably 60/40 to 20/80, and still more preferably 35/65 to 45/55.

The total amount of the polyethylene terephthalate and polybutylene terephthalate in the resin composition (2) preferably account for 70 wt% or more and 100 wt% or less of the total components (100 wt%) of the resin composition (2). The total amount of the polyethylene terephthalate and polybutylene terephthalate in the resin composition (2) more preferably account for 80 wt% or more and 100 wt% or less of the total components of the resin composition (2), still more preferably 90 wt% or more and 100 wt% or less of the total components of the resin composition (2).

Of the aliphatic polyesters, a polylactic acid produced through polymerization using L-lactic acid and/or D-lactic acid as main constituents is used particularly preferably as the primary component of the resin composition (2). This polylactic acid may also contain a copolymerization component other than the lactic acid, and such other monomer units include glycol compounds such as ethylene glycol, propylene glycol, butanediol, heptanediol, hexanediol, octanediol, nonane diol, decanediol, 1,4-cyclohexane dimethanol, neopentyl glycol, glycerin, pentaerythritol, bisphenol A, polyethylene glycol, polypropylene glycol, and polytetramethylene glycol; dicarboxylic acids such as oxalic acid, adipic acid, sebacic acid, azelaic acid, dodecanedioic acid, malonic acid, glutaric acid, cyclohexane dicarboxylic acid, terephthalic acid, isophthalic acid, phthalic acid, naphthalene dicarboxylic acid, bis(p-carboxy phenyl) methane, anthracene dicarboxylic acid, 4,4'-diphenyl ether dicarboxylic acid, 5-sodium sulfoisophthalic acid, and 5-tetrabutyl phosphonium isophthalic acid; hydroxy carboxylic acids such as glycolic acid, hydroxy propionic acid, hydroxy butyric acid, hydroxy valeric acid, hydroxy caproic acid, and hydroxy benzoic acid; and lactones such as caprolactone, valerolactone, propiolactone, undeca lactone, and 1,5-oxepane-2-on.

If a polylactic acid is used as the primary component of the resin composition (2), it is preferable that a plasticizer etc. or an amorphous polylactic acid component that serve to lower the glass transition temperature of the polylactic acid is contained in the resin composition (2) to allow stretching at 70°C or less.

The polyolefin to be used as the primary component of the resin layer (B) composed of the resin composition (2) is preferably at least one or more selected from the following: polypropylene resin, polyethylene resin, ethylene-propylene random copolymer, ethylene-propylene block copolymer, ethylene-propylene-butene random copolymer, and propylene-butene random copolymer. Two or more these polyolefin resins may be used in combination unless they impair the effect of the invention.

For the invention, there are no specific limitations on the method to produce polyolefin resin, and generally known methods may serve effectively. For polypropylene resins, they include, for instance, radical polymerization, coordination polymerization using a Ziegler-Natta catalyst, anion polymerization, and coordination polymerization using a metallocene catalyst.

These polyolefin resins preferably have a melt flow index (MI) in the range of 1 to 100 g/10 min, more preferably 2 to 80 g/10 min, and still more preferably 4 to 60 g/10 min, as measured according to JIS-K7210. A polyolefin resin in this range will have an appropriate crystallizability and serve to produce a laminated film according to the invention having a high dimensional stability, moisture resistance, and surface smoothness. If the value of MI is less than 1 g/10 min, the melt viscosity will be too high, and the extrudability will decrease easily. If the value of MI exceeds 100 g/10 min, on the other hand, the mechanical characteristics of the film will be likely to deteriorate largely.

The polyolefin resins should have an intrinsic viscosity [η] of 1.4 to 3.2 dl/g, preferably 1.6 to 2.4 dl/g. The film will be brittle if the viscosity [η] is less than 1.4 dl/g, whereas the crystallizability can decrease of it exceeds 3.2 dl/g.

### Described below is the production method for the vapor deposited film of the invention.

The resin composition (1) for the resin layer (A) is fed to the extruder, and after filtration to remove foreign objects and adjustment of the flow rate through the gear pump, discharged from the orifice to form a sheet. Using an air knife or applying static electricity, the sheet is brought into contact with a casting drum for cooling and solidification to produce an unstretched film. When the resin layer (B) is laminated, the resin composition (2) for the resin layer (B) is supplied to another extruder, and after filtration to remove foreign objects in a separate flow channel and adjustment of the flow rate through the gear pump, the flows are combined into a layered state in a multi-layered orifice, a feedblock installed at the top portion of an orifice, or an orifice containing multiple manifolds, and discharged to form a sheet. Using an air knife or applying static electricity, the sheet is brought into contact with a casting drum for cooling and solidification to produce an unstretched film.

To protect the surface from gel, heat-degraded components, and other foreign objects, a filter with an average aperture of 5 to 40 µm produced by sintering and compressing stainless steel fiber is preferably used for filtration in the film production step. It is preferable to perform sequential filtration through said filter produced by sintering and compressing stainless steel fiber followed by a filter with an average aperture of 10 to 50 µm produced by sintering and compressing stainless steel powder. Instead, it is also preferable to use a composite filter consisting of these two filters combined in a capsule, which serves to remove gel and heat-degraded components efficiently and allows film's edges and ends to be recycled to achieve cost reduction.

Then, in the case of sequential biaxial stretching, said unstretched sheet is passed between rolls for preheating, stretched in the length direction between rolls with different circumferential speeds, and immediately cooled to room temperature to provide a stretched film, which is then supplied to a tenter, stretched and heat-fixed while being relaxed in the width direction, and finally wound up. Instead, stretching may be achieved by simultaneous stretching in the length direction and in the horizontal direction, or stretching may be achieved by repeated stretching in the length direction and in the horizontal direction.

Simultaneous biaxial stretching in a tenter is advantageous in view of surface smoothness because crystallizability of the polyglycolic acid is increased compared with uniaxial stretching, and the surface of the resin layer (A) will be less likely to become rough. In addition, stretchability is higher compared with sequential biaxial stretching, making it possible to increase the elastic modulus and orientation, which is preferable.

With respect to the stretching conditions for the base film, it is preferable that stretching is carried out at 70°C or less in order to allow adjustment of the crystallizability and orientation of the resin layer (A), and smoothing of the surface. Specifically, the stretching temperature in the length direction is preferably controlled in the range of 40 to 70°C. The stretching temperature in the length direction is more preferably 40 to 65°C, and still more preferably 50°C to 60°C. The longitudinal stretching ratio is preferably in the range of 2.0 to 5.0, more preferably 2.5 to 4.5, and still more preferably 3.0 to 4.5. The stretching temperature in the width direction is also preferably 70°C or less, and specifically, a temperature of 40 to 70°C is preferable. The stretching temperature in the width direction is more preferably 40 to 65°C, and still more preferably 45 to 55°C. The transverse stretching ratio is preferably 2.0 to 5.0, more preferably 2.5 to 4.5, and still more preferably 3.0 to 4.5. In the case of sequential biaxial stretching, if the stretching temperature exceeds 70°C, crystallization of the polyglycolic acid proceeds to a large degree in the transverse stretching step, making the surface more likely to become rough after heat fixation. If the two-dimensional stretching ratio, which is the product of the longitudinal stretching ratio multiplied by the transverse stretching ratio, is 4.0 or less, thermal crystallization of the polyglycolic acid proceeds to a large degree in the heat fixation step, possibly making the surface rough.

After the stretching, heat treatment for relaxation is carried out preferably in the temperature range from 120°C up to the melting point of the resin composition (1), more preferably from 150°C up to a temperature 10°C below the melting point of the resin composition (1), and still more preferably from 170°C up to a temperature 20°C below the melting point of the resin composition (1), followed by cooling. Appropriate stretching after heat treatment for relaxation in said range serves to maintain surface smoothness of the resin layer (A) and produce a film that has a low heat shrinkage degree, high elastic modulus, plane orientation coefficient in a certain range, and curl-free highly flat surface. If the heat treatment for relaxation is carried out at a temperature higher than the melting point of the resin composition (1), the polyglycolic acid crystal will melt and loose orientation, and its surface will likely to become rough after crystallization of the resin layer (A) at a lowered temperature. If the heat treatment for relaxation is carried out at a temperature below 120°C, on the other hand, the film will be very low in heat resistance and can suffer troubles such as shrinkage during the deposition step.

The resulting stretched film is then subjected to a deposition process. The useful metals and inorganic oxides for vapor deposition include aluminum, aluminum oxide, silicon oxide, silicon nitride, cerium dioxide, oxidation calcium, diamond-like carbon film, and mixtures thereof, of which aluminum, aluminum oxide, and silicon oxide are more preferable in view of gas barrier properties and productivity. An aluminum vapor deposited layer is preferable because of high economic efficiency and high gas barrier properties, and an aluminum oxide or silicon oxide vapor deposited layer is preferable because of high transparency and small required cost. The vapor deposited film of the invention at least comprises the resin layer (A), and a vapor deposited layer is formed over at least one side the resin layer (A). In the case of a base film consisting of the resin layer (A) and the resin layer (B), there are no specific limitations on the side on which the vapor deposited layer is to be formed, but a preferable layer constitution is such that the resin layer (A) is covered with the vapor deposited layer because decomposition of the resin layer (A) is depressed. Specifically, the constitution of resin layer (B)/resin layer (A)/vapor deposited layer laminated in this order is preferable. In the case of a base film of monolayer constitution consisting of the resin layer (A) alone or a base film of the constitution of resin layer (A)/resin layer (B)/ resin layer (A) laminated in this order, a vapor deposited layer may be formed over both sides of the base film to improve the gas barrier properties, though it requires higher cost compared with vapor deposition on only one side.

A vacuum processing method is used to form a vapor deposited layer to produce the vapor deposited film of the invention. The appropriate vacuum processing methods include vacuum deposition, sputtering, ion plating, and chemical vapor deposition, any of which may be useful. For instance, reactive deposition is more preferable in forming an inorganic oxide vapor deposited layer in view of productivity and required cost.

Before carrying out said vacuum processing, the non-deposited film surface is preferably subjected to plasma treatment or corona treatment to achieve further improved gas barrier properties. The degree of corona treatment is preferably in the range of 5 to 50 W·min/m², more preferably 10 to 45 W·min/m². Formation of a nuclei-carrying metal vapor deposited layer by plasma discharge before carrying out vapor deposition of a metal or inorganic oxide is preferable in order to improve the contact of the vapor deposited layer. In this case, the use of copper is most preferable if said plasma discharge is to be carried out in an oxygen and/or nitrogen gas atmosphere.

Reactive deposition of aluminum oxide is performed by vaporizing aluminum metal or alumina using a resistance heating boat, high frequency induction heating crucible, or electron beam heating device and depositing aluminum oxide on a film in an oxidizing atmosphere. Oxygen is generally used as the reactive gas to form said oxidizing atmosphere, but a mixture gas consisting mainly of oxygen in combination with moisture or a rare gas may also be used. This may be further combined with ozone addition or ion assisting to accelerate the reaction. To form a silicon oxide vapor deposited layer by reactive deposition, Si metal, SiO or SiO₂ is vaporized by electron beam heating, followed by depositing silicon oxide over a film in an oxidizing atmosphere. The aforementioned method may serve to produce an oxidizing atmosphere.

There are no particular limitations on the thickness of the vapor deposited layer, but in view of the productivity, handleability, and appearance, it is preferably 5 to 100 nm, more preferably 5 to 50 nm, and still more preferably 5 to 30 nm. If the thickness of the vapor deposited layer is less than 5 nm, the vapor deposited layer can suffer defects and gas barrier properties can deteriorate. If the thickness of the vapor deposited layer is more than 100 nm, large cost will be required for the deposition step and the vapor deposited layer will have an undesirable color to impair the appearance, which is not preferred.

Higher gas barrier properties will be achieved by combining the vapor deposited film of the invention with a coating technique. Significantly, if an anchor coating agent is applied in advance by an in-line or off-line device to form an anchor coat layer over the resin layer (A), a good contact will be achieved with the vapor deposited layer formed on the anchor coat layer to improve the gas barrier properties effectively (the vapor deposited film of the invention this case at least has the structure of resin layer (A)/anchor coat layer/vapor deposited layer laminated in this order).

An overcoat layer formed by applying an overcoating agent over the vapor deposited layer serves to correct defects in the vapor deposited layer to improve the gas barrier properties (the vapor deposited film of the invention this case at least has the structure of resin layer (A)/vapor deposited layer/overcoat layer laminated in this order).
The preferable resins to be used as said anchor coating agent and overcoating agent (hereinafter, anchor coating agent and overcoating agent are simply referred to as coating agents) may be at least one selected from the following: polyvinylidene chloride, polyvinyl alcohol, polyethylene-vinyl alcohol, acrylate, polyacrylonitrile, polyester, polyurethane, and polyester-polyurethane resin. In particular, coating materials composed of at least one resin selected from the group of polyethylene-vinyl alcohol, polyacrylonitrile, and polyurethane resins can prevent the resin layer (A) from being decomposed to form oligomers and also serve to complement the gas barrier properties.

In coating materials composed of an ethylene-vinyl alcohol resin, it is preferable that the ethylene component accounts for 1 to 50 mol%, more preferably 2 to 40 mol%, of the total monomer units (100 mol%) in the ethylene-vinyl alcohol resin. An ethylene component of less than 1 mol% will lead to decreased compatibility with the resin layer (A) and decreased transparency of the anchor coat layer, whereas an ethylene component of more than 50 mol% will lead to decreased solubility of the ethylene-vinyl alcohol resin in the solvent and decrease processability. The saponification degree is preferably 95 mol% or more, , more preferably 97 mol% or more.

In coating materials composed of a polyacrylonitrile resin, the nitrile group preferably accounts for 5 to 70 wt%, more preferably 10 to 50 wt%, of the total amount (100 wt%) of the polyacrylonitrile resin. A content in said range is preferable because it serves to achieve a improved balance among gas barrier properties, uniformity of the coated film, and handleability of the coating material. Said polyacrylonitrile resin preferably has a glass transition temperature of 50°C to 100°C in view of uniformity of the coated film.

For said polyacrylonitrile resins, the useful monomers for copolymerization with acrylonitrile include, for instance, ethylene-unsaturated carboxylates such as various acrylates and various methacrylates; acrylic amide and methacrylic amide; ethylene-unsaturated carboxylic acids such as acrylic acid and methacrylic acid; vinyl esters such as vinyl acetate; styrene-based monomers such as styrene and methyl styrene; and methacrylonitrile.

In said polyurethane resin, which is the primary component of urethane-based coating materials, the total content of the urethane group and urea group is preferably high to maintain high gas barrier properties. However, emulsification will be difficult if the total content of the urethane group and urea group is too high, and therefore, the urethane group and urea group preferably altogether account for 20 to 70 wt%, more preferably 25 to 60 wt% of the total amount (100 wt%) of the polyurethane resin. Here, the content of the urethane group is defined as the molecular weight of the urethane group divided by that of the repeating unit, whereas the content of the urea group is defined as the molecular weight of the urea group divided by that of the repeating unit.

In the polyurethane resin in said urethane-based coating material, the isocyanate component is preferably 1,3- or 1,4-xylylene diisocyanate, 1,3- or 1,4-tetra methyl xylylene diisocyanate, or 1,3- or 1,4-bis(isocyanate methyl) cyclohexane, while the polyol component is preferably 1,3- or 1,4-xylylene diol, or hydrogenerated xylylene diol, to achieve high gas barrier properties, and combinations thereof are preferable.

These coating agents may contain a crosslinking agent as needed to improve the water resistance and gas barrier properties, which is preferable. Various crosslinking agents composed mainly of epoxy, amine, melamine, isocyanate, or oxazoline, and various coupling agents such as titanium coupling agent and silane coupling agent are preferably used.

The coating weight of said coating agents is preferably in the range of 0.01 to 2 g/m², more preferably 0.01 to 1 g/m². If the coating weight is less than 0.01 g/m², defects such as film breakage and cissing can be caused and formation of uniform resin will be difficult even during in-line coating which can produce relatively thin resin films. Furthermore, sufficient gas barrier properties tend to be difficult to develop if an inorganic oxide layer is formed over a resin layer. A coating weight of more than 2 g/m² is not preferable, on the other hand, because drying in the coating step will need to be performed at a high temperature for an increased period of time to vaporize the solvent sufficiently, and the film tends to suffer deformation such as curling. Furthermore, there will be problems such as residual solvent and large required cost.

### Examples

The vapor deposited film according to the present invention will be illustrated below with reference to Examples.

### <Methods for evaluation of properties>

The methods for properties evaluation used for the invention are as followed.

### [Molecular weight]

Using hexafluoroisopropanol as solvent, a specimen was allowed to pass through a column (HFIP-LG + HFIP-806M × 2: Shodex) at 40°C and 1 mL/min. A calibration curve was prepared in advance from elution time measurements based on detection of the differential refractive index of PMMA (polymethyl methacrylate) standard substances with a known molecular weight of 827,000, 101,000, 34,000, 10,000, or 2,000. The weight average molecular weight of the specimen was calculated from the measured elution time.

For polyglycolic acid, however, Shodex-104 supplied by Showa Denko K.K. was used, and hexafluoroisopropanol containing 5 mM trifluorosodium acetate was used as solvent. A specimen was allowed to pass through a column (HFIP-606M × 2, plus precolumn) at 40°C and 0.6 mL/min. Calibration curves were prepared in advance from elution time measurements based on detection of the differential refractive index of seven PMMA standard substances with different molecular weights. The weight average molecular weight of the specimen was calculated from the measured elution time.

### [Content of copolymerization component]

JNM-30AL400 supplied by JEOL Ltd. was used to obtain spectral data by solution-type proton nuclear magnetic resonance (1H-NMR), and the content in wt% was calculated from the composition ratio measured from the integral intensity of each peak.

The measuring conditions included use of deuterated chloroform as solvent, dissolution at room temperature, specimen concentration of 20 mg/mL, impulse width of 11 µs/45°, pulse repeating time of 9 seconds, 256 integration points, and 23°C.

For polyglycolic acid, however, AVANCE 400 supplied by Bruker was used to obtain spectral data by solution-type proton nuclear magnetic resonance (1H-NMR), and the content in wt% was calculated from the composition ratio measured from the integral intensity of each peak. The measure conditions included use of solvent of CDCl3 : HFIP = 1 : 1, dissolution at room temperature, specimen concentration of 20 mg/mL, pulse width of 4.4 µs/45°, measuring time of 9 seconds, 8 integration points, and 27°C.

### [Melt viscosity]

A CFT-500 flow tester (supplied by Shimadzu Corporation) was used for measurement under the following conditions: orifice length of 10 mm, orifice diameter of 1.0 mm, load of 5, 10, 15, or 20 kg, measuring temperature of 270°C, and preheating time of 5 min. The relation between the shear velocity and the melt viscosity was measured to the melt viscosity at about 100 sec⁻¹.

### [Glass transition temperature (Tg) of the resin composition (2)]

A Robot DSC-RDC220 differential scanning calorimeter supplied by Seico Electronics industrial Co., Ltd. was used for measurement according to JIS-K7121 (1999), together with Disk Session SSC/5200 for data analysis. A 5 mg specimen of the resin composition (2) taken from the resin layer (B) was weighed out on a sample pan, and scanning was carried out at a heating rate of 20°C/min. In the stepwise glass transition changing portion in a differential scanning calorimetry chart, Tg was determined from the intersection points of the lines located at the same distances in the longitudinal axis direction from the extension of each baseline and the curves in the stepwise glass transition changing portion.

### [Center line average surface roughness (Ra) of the resin layer (A)]

A stylus-type surface roughness tester (supplied by Kosaka Laboratory Ltd., high accuracy thin membrane step measuring apparatus, Model ET30HK) was used according to JIS-B0601 (1976) to investigate the vapor deposited surface of the film (base film). The measuring conditions included a stylus diameter (circular cone) of 0.5 µmR, load of 16 mg, and cut-off of 0.08 mm. From the roughness curve, a portion with a measuring length L was cut out in the center line direction, and the X and Y axes were assumed to be in the center line of this cut-out portion and in the vertical direction, respectively. Assuming that the roughness curve is represented as y = f(X), the center line average surface roughness Ra (µm) was determined from the following equation:
Ra=(1/L)∫|f(X)|dx. Five measurements were taken at randomly selected different points in each sample, and the average of the five measurements was taken as Ra.

### [Number of foreign objects]

The base film was observed through a polarizing plate to record the number of foreign objects, defects, and fish eyes (number/m²). Measurement was performed under the conditions of 100 mm × 100 mm, and N = 5.

### [Film thickness]

A dial-type thickness gauge was used to take measurements according to JIS-B7509 (1955).

### [Laminated layer thickness ratio]

A microtome was used to prepare ultrathin sections to observe the length direction - thickness direction cross section of the film. For these thin sections for cross section observation, a transmission electron microscope was used to take photographs of the film's cross sections at a magnification of 20,000x, and the thickness of each layer in the width center portion of the film was measured.

### [Tensile modulus of the resin layer (A)]

The tensile modulus of the resin layer (A) in the base film was measured according to ASTM D882-64T (2002). When the base film is a laminate consisting of the resin layer (A) and the resin layer (B), the tensile modulus of the entire laminated film was measured first, and after peeling off the resin layer (A), the tensile modulus of the film composed only of the resin layer (B) was measured, followed by calculation of the tensile modulus of the resin layer (A) on the assumption that the tensile modulus of each layer is in proportion to the thickness ratio.

### [Degree of heat shrinkage]

A rectangle with a size of length 150 mm × width 10 mm in the length direction and width direction, respectively, was cut out of the vapor deposited film to provide a sample. Gage marks were made at intervals of 100 mm on the sample, which was then loaded with a weight of 3g and heat-treated for 30 minutes in a hot air oven heated at 150°C. The distance between the gage marks was measured after the heat treatment, and the degree of heat shrinkage was calculated from the difference in the gage mark interval measured before and after heating to provide an index for dimensional stability. For each vapor deposited film product, five samples were taken in the length and width directions, and their average was determined and used for the evaluation.

### [Plane orientation coefficient (fn) of the resin layer (A)]

A light source of the sodium D line (wavelength 589 nm) and an Abbe refractometer were used to measure the refractive index in the length direction (Nx), the refractive index in the width direction (Ny), and the refractive index in the thickness direction (Nz) of the resin layer (A) side surface of the base film, and the plane orientation coefficient (fn) was calculated by the following equation. Diiodomethane was used for the mounting solution.
fn=(Nx+Ny)/2-Nz

### [Oxygen transmittance]

Measurements were taken using an oxygen transmittance measuring machine (Model Ox-Tran (registered trademark) 2/20 supplied by Mocon, Inc. of U.S.A.) at a temperature 35°C and humidity of 0% RH according to the electrolytic sensor method specified in JIS-K7126-2 (2006). For the measurement, an oxygen flow is applied to the vapor deposited layer side surface, and detection was performed on the opposite side. Two measurements were taken and they were averaged to determine the oxygen transmittance value for each Example and Comparative example. Measurements were taken from two test pieces to give an oxygen transmittance value representing each Example and Comparative example.

### [Carbon dioxide gas transmittance]

Measurements were taken using a mixed gas transmittance measuring machine (GPM-250 supplied by GL Sciences, Inc.) at a temperature 35°C and humidity of 0% RH according to the gas chromatography method specified in JIS-K7126-2 (2006). For the measurement, a carbon dioxide flow is applied to the vapor deposited layer side surface, and detection was performed on the opposite side to the vapor deposited layer. Two measurements were taken and they were averaged to determine the carbon dioxide transmittance value for each Example and Comparative example. Measurements were taken from two test pieces to give a carbon dioxide transmittance value representing each Example and Comparative example.

### [Moisture transmittance]

Moisture transmittance measurements were taken using a moisture transmittance measuring machine (Model Permatran (registered trademark) W3/31 supplied by Mocon, Inc. of U.S.A.) at a temperature 40°C and humidity of 90% RH according to the B method (infrared sensor method) specified in JIS-K7129 (2000). For the measurement, a moisture flow is applied to the vapor deposited layer side surface, and detection was performed on the opposite side to the vapor deposited layer. Two measurements were taken and they were averaged to determine the moisture transmittance value for each Example and Comparative example. Measurements were taken from two test pieces to give a moisture transmittance value representing each Example and Comparative example.

Described below are the input materials and coating agents used in the Examples and Comparative examples of the invention.

### [Polymerization of polyethylene terephthalate (PET)]

First, 0.1 part by weight of magnesium acetate tetrahydrate and 0.05 part by weight of antimony trioxide were added to 194 parts by weight of dimethyl terephthalate and 124 parts by weight of ethylene glycol, and ester interchange reaction was carried out while distilling out methanol at 140 to 230°C. Then, the material was transferred to a condensation polymerization reaction vessel and an ethylene glycol solution containing 0.05 part by weight of phosphoric acid was added, followed by stirring for 5 minutes. As the low polymer was stirred at 30 rpm, the reaction system was gradually heated from 230°C to 290°C and the pressure was reduced to 100 Pa. After maintaining the polymerization reaction for 3 hours, the condensation polymerization reaction was stopped when the stirring torque reached a predetermined value, and the material was discharged into cold water to form a strand, which was immediately cut into small pieces. Subsequently, they were fed to a rotary reaction container and solid phase polymerization was carried out for 5 hours at 190°C and a reduced pressure of 67 Pa to produce polyethylene terephthalate pellets with an intrinsic viscosity of 0.79. Their melt viscosity was 4,800 poise at 270°C · 100 sec⁻¹.

### [Polymerization of polybutylene terephthalate (PBT)]

A mixture of 100 parts by weight of terephthalic acid and 110 parts by weight of 1,4-butanediol was heated in a nitrogen atmosphere up to 140°C to produce a uniform solution. Subsequently, 0.067 part by weight of tetra-n-butyl orthotitanate and 0.067 part by weight of monohydroxy butyl tin oxide were added and heated to 160°C-230°C, and esterification reaction was carried out while distilling out the resulting water and tetrahydrofuran. The esterification reaction product was transferred to a condensation polymerization reaction vessel, and 0.09 part by weight of tetra-n-butyl titanate, 0.13 part by weight of a stabilizer (Irganox 1010 supplied by Ciba-Geigy Japan Ltd.), and 0.026 part by weight of phosphoric acid were added. Then, the reaction system was heated gradually from 230°C up to 250°C while reducing the pressure from atmospheric pressure down to below 133 Pa. The condensation polymerization reaction was stopped after 2 hours 50 minutes, and discharged into cold water to form a strand, which was immediately cut into pieces to produce polybutylene terephthalate pellets with an intrinsic viscosity of 0.90. Subsequently, they were fed to a rotary reaction container and solid phase polymerization was carried out for 8 hours at 190°C and a reduced pressure of 67 Pa to produce polybutylene terephthalate resin. The resulting polybutylene terephthalate resin had an intrinsic viscosity 1.20, melting point of 230°C, and melt viscosity of 3,000 poise at 270°C · 100 sec⁻¹.

### [Polymerization of polyethylene terephthalate/dimer acid copolymerized polyester (PET-DA)]

First, 8 parts by weight of a hydrogenated dimer acid (PRIPOL 1009 supplied by Uniqema GmbH & Co. KG) was added to 150 parts by weight of terephthalic acid and 87 parts by weight of ethylene glycol and heated up to 140°C in a nitrogen atmosphere to produce a uniform solution. Subsequently, the material was heated and compressed to 160°C-230°C and 0.2 MPa, and esterification reaction was carried out while distilling out the resulting water. Then, the material was transferred to a condensation polymerization reaction vessel. An ethylene glycol solution containing 0.05 part by weight of phosphoric acid was added, and 0.05 parts by weight of antimony trioxide was also added, followed by stirring for 5 minutes. As the low polymer was stirred at 30 rpm, the reaction system was gradually heated from 230°C to 290°C and the pressure was reduced to 100 Pa. After maintaining the polymerization reaction for 3 hours, the condensation polymerization reaction was stopped when the stirring torque reached a predetermined value, and the material was discharged into cold water to form a strand, which was immediately cut into small pieces. Subsequently, they were dried in a rotary vacuum dryer at 140°C for 4 hours to produce a copolymerized polyester with an intrinsic viscosity of 0.72 (melting point 245°C).

Their melt viscosity was 3,000 poise at 270°C · 100 sec⁻¹.

### (PPT)

A polypropylene terephthalate resin (Corterra (registered trademark) CP509201 supplied by Shell Chemical Company) with an intrinsic viscosity of 0.9 dl/g and melting point of 222°C was obtained.

### (PGA 1)

A homo-polyglycolic acid resin with a molecular weight of 180,000, melting point of 221°C, Tg of 42°C, and a melt viscosity of 3,500 poise at 270°C · 100 see⁻¹ was obtained and dried in a rotary vacuum dryer at 150°C for 4 hours.

### (PGA 2)

A polyglycolic acid copolymerized with 10 moles of L-lactide with a molecular weight of 170,000, melting point of 205°C, Tg of 40°C, and a melt viscosity of 3,000 poise at 270°C · 100 sec⁻¹ was obtained.

### (PGA 3)

A polyglycolic acid copolymerized with 18 moles of L-lactide with a molecular weight of 170,000, melting point of 190°C, Tg of 40°C, and a melt viscosity of 3,000 poise at 270°C · 100 sec⁻¹ was obtained.

### (PLA 1)

To prepare a plasticizer, 0.07 part by weight of tin octylate was mixed with 72 parts by weight of polyethylene glycol with an average molecular weight of 12,000 and 28 parts by weight of L-lactide, and polymerized in a reaction container equipped with a stirrer in a nitrogen atmosphere at 190°C for 60 minutes to produce a block copolymer consisting of polyethylene glycol and polylactic acid in which the polylactic acid segment had an average molecular weight 2,330. A mixture of 80 parts by weight of a polylactic acid (supplied by Nature Works LLC, D-form 1.2 mol%, molecular weight 160,000, melting point 168°C, Tg 58°C), 20 parts by weight of the plasticizer, and 0.5 parts by weight of carbodiimide-based crosslinking agent (Carbodilite (registered trademark) LA-1 supplied by Nisshinbo Industries, Inc.) was vacuum-dried at a reduced pressure of 5 torr and 100°C for 4 hours, fed to a biaxial kneading extruder with a cylinder temperature of 190°C, and melt-kneaded to produce a homogeneous composition, which was then chipped. Subsequently, the material was dried in a rotary vacuum dryer at 100°C for 4 hours.

### (PLA 2)

A bend for practical use was prepared by mixing 70 parts by weight of pellets of a polylactic acid (supplied by Nature Works LLC, D-form 1.2 mol%, molecular weight of 160,000, melting point of 168°C, Tg of 58°C) dried at 100°C for 4 hours in a rotary vacuum dryer and 30 parts by weight of pellets a polylactic acid (supplied by Nature Works LLC, D-form 12 mol%, molecular weight of 160,000, Tg of 58°C) dried at 50°C for 8 hours in a rotary vacuum dryer.

The undermentioned coating materials were obtained for use as anchor coating agent and overcoating agent.

### (EVOH coating material)

An ethylene-vinyl alcohol coating material (Exceval (registered trademark) RS-4105, supplied by Kuraray Co., Ltd., ethylene content 5 mol%, saponification degree 98.5 mol%) was diluted with water/isopropyl alcohol (weight ratio 9:1) to provide a solution with a solids content of 10 wt%.

### (PAN coating material)

A poly acrylonitrile coating material with a molecular weight of 36,000, hydroxyl value of 70 mg (KOH/g), Tg of 93°C, and nitrile content of 18 wt% was diluted with methyl ethyl ketone provide a solution with a solids content of 10 wt%.

### (Polyurethane coating material)

A polyurethane coating material with a total urethane and urea group content of 32.5 wt% and acid value of 25.1 mg (KOH/g) was diluted with water/isopropyl alcohol (weight ratio 9:1) with a solids content of 10 wt%.

### (Example 1)

As the resin composition (1) in the resin layer (A), 100 parts by weight of PGA 1 was supplied to the single screw extruder 1 and extruded at 265°C, and the polymer was filtered through a filter with an average aperture of 25 µm produced by sintering and compressing stainless steel fiber, and discharged through an orifice. Then, the polymer was wound up on a drum adjusted to a temperature of 25°C to cool and solidify to form a sheet. Said film was stretched 4.4-fold by rolls at 60°C in the length direction, immediately cooled to room temperature, fed to a tenter, stretched 4.4-fold at 50°C in the width direction, and then, while maintaining a 5% relaxation in the width direction, heat-treated at a temperature of 190°C to provide a biaxially stretched film. The resulting film had a thickness of 15 µm.

The resulting film was subjected to corona discharge treatment at 30 W·min/m² and film temperature of 60°C in an mixed gas atmosphere of nitrogen and carbon dioxide gas (carbon dioxide gas content 15 vol.%), and wound up. The film was fed to a vacuum deposition apparatus equipped with a film traveling mechanism, and after reducing the pressure down to 1.00 × 10⁻² Pa, allowed to travel on a cooled metal drum of 20°C. During this step, aluminum metal was heated to vaporize to form a vapor deposited layer. After the deposition step, the pressure in the vacuum deposition apparatus was increased to atmospheric pressure, and the wound-up film was rewound, followed by aging at a temperature of 40°C for 2 days to provide a vapor deposited film. While the optical density of the vapor deposited film was monitored in-line during the deposition step, the deposition thickness was controlled to adjust it to 2.5.

### (Examples 2, 3, 6, and 7)

Except that the stretching and heat treatment conditions were set up as described in Table 1, the same procedure as in Example 1 was carried out to produce a film with a film thickness of 15.0 µm, followed by carrying out a deposition process to produce a vapor deposited film.

### (Example 4)

Except that 100 parts by weight of PGA 2 was used as the resin composition (1) and that the stretching and heat treatment conditions were set up as described in Table 1, the same procedure as in Example 1 was carried out to produce a film with a film thickness of 15.0 µm, followed by carrying out a deposition process to produce a vapor deposited film.

### (Example 5)

Except that 100 parts by weight of PGA 3 was used as the resin composition (1) and that the stretching and heat treatment conditions were set up as described in Table 1, the same procedure as in Example 1 was carried out to produce a film with a film thickness of 15.0 µm, followed by carrying out a deposition process to produce a vapor deposited film.

### (Comparative example 1)

Except that the polymer filtration through a filter was not carried out in the extrusion step and that the stretching and heat treatment conditions were set up as described in Table 1, the same procedure as in Example 1 was carried out to produce a film with a film thickness of 15.0 µm, followed by carrying out a deposition process to produce a vapor deposited film.

### (Comparative example 2)

As the resin composition (1) in the resin layer (A), 100 parts by weight of PET 1 was supplied to the single screw extruder 1 and extruded at 285°C, and the polymer was filtered through a filter with an average aperture of 15 µm produced by sintering and compressing stainless steel fiber, and discharged through an orifice. Then, the polymer was wound up on a drum adjusted to a temperature of 25°C to cool and solidify it to form a sheet. Said film was stretched 3.8-fold by rolls at 90°C in the length direction, immediately cooled to room temperature, fed to a tenter, stretched 3.9-fold at 100°C in the width direction, and then, while maintaining a 5% relaxation in the width direction, heat-treated at a temperature of 230°C to provide a biaxially stretched film. The resulting film had a thickness of 15.0 µm. Then, a deposition process was carried out as in Example 1 to produce a vapor deposited film.

Results are shown in Table 1.
The abbreviations are as described below.
MD: film's length direction
TD: film's width direction
PGA1: polyglycolic acid
PGA2: polyglycolic acid copolymerized with 10 moles of L lactide
PGA3: polyglycolic acid copolymerized with 15 moles of L lactide
fn: plane orientation coefficient

[Table 1]

**[Table 1]**

| | | Example 1 | Example 2 | Example 3 | Example 4 | Example 5 | Example 6 | Example 7 | Comparative example 1 | Comparative example 2 |
|---|---|---|---|---|---|---|---|---|---|---|
| Resin layer (A) | Component | PGA1 | PGA 1 | PGA 1 | PGA 2 | PGA 3 | PGA 1 | PGA 1 | PGA 1 | PET |
| | Parts by weight of | 100 | 100 | 100 | 100 | 100 | 100 | 100 | 100 | 100 |
| Film layer constitution | | monolayer | monolayer | monolayer | monolayer | monolayer | monolayer | monolayer | monolayer | monolayer |
| Longitudinal drawing | Temperature | 60 | 60 | 55 | 60 | 60 | 55 | 55 | 60 | 90 |
| | Ratio | 4.4 | 2.1 | 3.5 | 2.5 | 2.1 | 3.5 | 4.1 | 3.5 | 3.8 |
| Transverse drawing | Temperature | 50 | 50 | 45 | 50 | 50 | 45 | 50 | 50 | 100 |
| | Ratio | 4.4 | 2.3 | 3.5 | 2.5 | 2.3 | 3.5 | 4.3 | 3.5 | 3.9 |
| Heat fixation | Temperature | 190 | 190 | 160 | 190 | 180 | 120 | 190 | 190 | 230 |
| Vapor deposited layer | | aluminum | aluminum | aluminum | aluminum | aluminum | aluminum | aluminum | aluminum | aluminum |
| Center line average roughness | Ra | 15 | 46 | 28 | 25 | 23 | 23 | 7 | 53 | 25 |
| Foreign objects | Number/m² | 0 | 0 | 0 | 0 | 0 | 0 | 0 | 13 | 0 |
| Heat shrinkage degree | MD | 3.1 | 1.8 | 7.3 | 2.1 | 2.8 | 13.1 | 4.2 | 2.8 | 0.5 |
| | TD | 4.5 | 1.6 | 6.2 | 2.3 | 3.2 | 12.6 | 4.6 | 3.1 | 0.2 |
| Tensile modulus | MD | 6.7 | 5.3 | 6.1 | 4.2 | 2.8 | 5.9 | 6.5 | 6.2 | 4.1 |
| | TD | 7.1 | 5.2 | 5.9 | 4.5 | 2.9 | 5.9 | 6.9 | 6.1 | 4.3 |
| fn | | 0.0678 | 0.0323 | 0.0462 | 0.0234 | 0.0091 | 0.0431 | 0.0633 | 0.0485 | 0.167 |
| Oxygen transmittance | cc/(m²·day· atm) | 0.42 | 0.62 | 0.53 | 0.68 | 0.71 | 0.90 | 0.39 | 1.80 | 1.20 |
| Carbon dioxide gas transmittance | cc/(m²_{·}day· atm) | 0.43 | 1.60 | 0.90 | 0.70 | 1.80 | 3.10 | 0.41 | 4.90 | 8.30 |

### (Example 8)

As the resin composition (1) in the resin layer (A), 100 parts by weight of PGA 1 was supplied to the single screw extruder 1 and extruded at 265°C, and the polymer was filtered through a filter with an average aperture of 25 µm produced by sintering and compressing stainless steel fiber. As the resin composition (2) in the resin layer (B), 60 parts by weight of PBT and 40 parts by weight of PET were supplied to the single screw extruder 2 and extruded at 270°C, and the polymer was filtered through a filter with an average aperture of 12 µm produced by sintering and compressing stainless steel fiber. They were discharged through a multi-layered orifice into a two-layer material consisting of the resin layer (A) and the resin layer (B), and wound up on a drum adjusted to a temperature of 25°C to cool and solidify to form a sheet. Said film was stretched 4.0-fold by rolls at 60°C in the length direction, immediately cooled to room temperature, fed to a tenter, stretched 4.0-fold at 50°C in the width direction, and then, while maintaining a 5% relaxation in the width direction, heat-treated at a temperature of 190°C to provide a biaxially stretched film. The resulting film had a thickness of 15.0 µm, and the thickness ratio between the resin layer (A) and the resin layer (B) was 1:5. The resulting film was subjected to corona discharge treatment at 30 W·min/m² and film temperature of 60°C in an mixed gas atmosphere of nitrogen and carbon dioxide gas (carbon dioxide gas content 15 vol.%), and wound up. The film was fed to a vacuum deposition apparatus equipped with a film traveling mechanism, and after reducing the pressure down to 1.00 × 10⁻² Pa, allowed to travel on a cooled metal drum of 20°C. During this step, aluminum metal was heated to vaporize while supplying oxygen gas to form a vapor deposited layer over the resin layer (A) side of the film. After the deposition step, the pressure in the vacuum deposition apparatus was increased to atmospheric pressure, and the wound-up film was rewound, followed by aging at a temperature of 40°C for 2 days to provide a vapor deposited film. The optical density of the vapor deposited film was monitored in-line during the deposition step, and controlled at 0.08.

### (Examples 9 to 13, and 18 to 20)

Except that the components of resin layer (B) and the stretching and heat treatment conditions were as described in Table 2, the same procedure as in Example 8 was carried out to produce a film with a film thickness of 15.0 µm, followed by carrying out a deposition process to produce a vapor deposited film.

### (Example 14)

Except that 80 parts by weight of PPT and 20 parts by weight of PET were used as the resin composition (2) in the resin layer (B), the same procedure as in Example 8 was carried out to produce a film with a film thickness of 15.0 µm, followed by carrying out a deposition process to produce a vapor deposited film.

### (Example 15)

Except that 100 parts by weight of PET-DA were used as the resin composition (2) in the resin layer (B), the same procedure as in Example 8 was carried out to produce a film with a film thickness of 15.0 µm, followed by carrying out a deposition process to produce a vapor deposited film.

### (Example 16)

The biaxially stretched film produced in Example 8 was subjected to the same corona treatment step as described above, and a vapor deposited film was produced using silicon oxide instead as vapor deposition source.

### (Example 17)

The biaxially stretched film produced in Example 9 was subjected to the same corona treatment step as described above, and a vapor deposited film was produced using silicon oxide instead as vapor deposition source.

### (Examples 21 to 25)

Except that the components of resin layer (B) were changed and that aluminum was used instead as vapor deposition source, the same procedure as in Example 8 was carried out to produce a vapor deposited film.

### (Comparative example 3)

Except that the polymer filtration through a filter was not carried out in the extrusion step and that the stretching and heat treatment conditions were set up as described in Table 2, the same procedure as in Example 7 was carried out to produce a film with a film thickness of 15.0 µm, followed by carrying out a deposition process to produce a vapor deposited film.

### (Comparative example 4)

The biaxially stretched film used in Comparative example 2 was subjected to corona treatment, and a vapor deposited film was produced by carrying out the same deposition process as in Example 7.

Results are shown in Table 2.
The abbreviations are as described below.
PBT: polybutylene terephthalate
PET: polyethylene terephthalate
PPT: polypropylene terephthalate
PET-DA: polyethylene terephthalate/dimer acid copolymerization polyester

[Table 2]

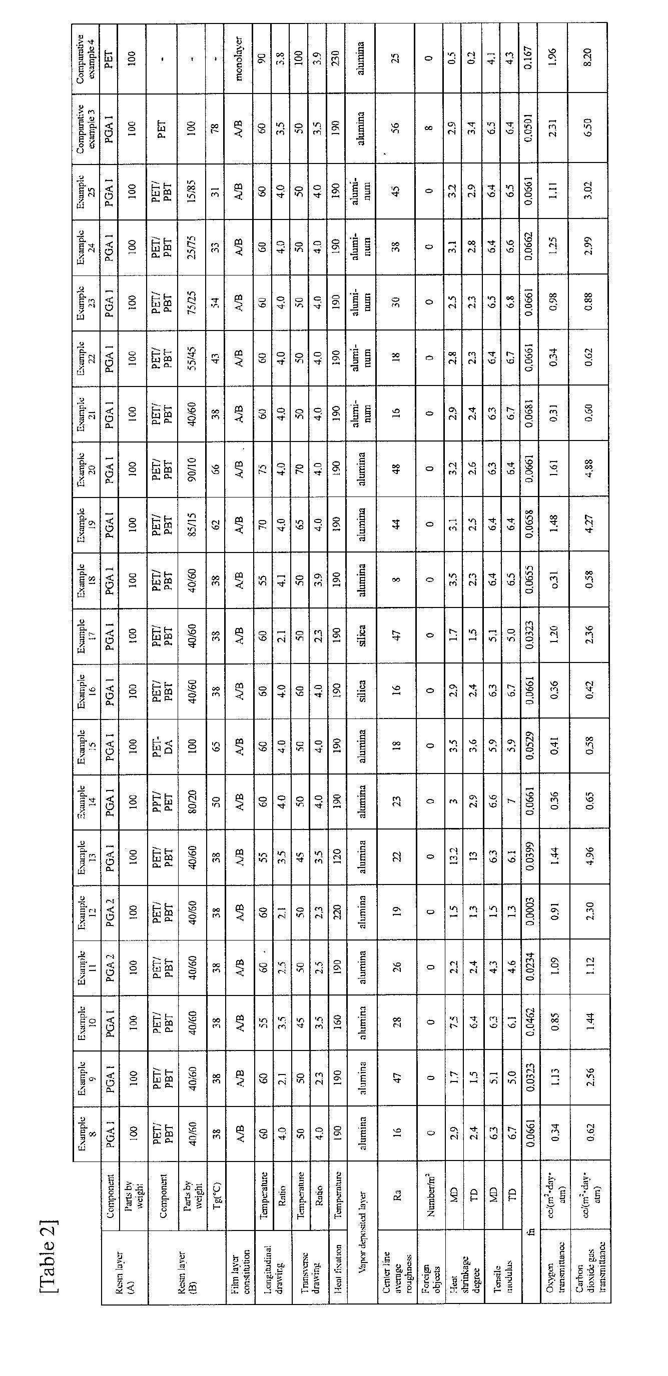

### (Example 26)

As the resin composition (1) in the resin layer (A), 100 parts by weight of PGA 2 was supplied to the single screw extruder 1 and extruded at 265°C, and the polymer was filtered through a filter with an average aperture of 25 µm produced by sintering and compressing stainless steel fiber. As the resin composition (2) in the resin layer (B), 100 parts by weight of PLA 1 was supplied to the single screw extruder 2 and extruded at 240°C, and the polymer was filtered through a filter with an average aperture of 25 µm produced by sintering and compressing stainless steel fiber. They were discharged through a multi-layered orifice into a two-layer material, and wound up on a drum adjusted to a temperature of 25°C to cool and solidify to form a sheet. Said film was stretched 3.0-fold by rolls at 60°C in the length direction, immediately cooled to room temperature, fed to a tenter, stretched 3.0-fold at 60°C in the width direction, and then, while maintaining a 5% relaxation in the width direction, heat-treated at a temperature of 150°C to provide a biaxially stretched film. The resulting film had a thickness of 15.0 µm, and the thickness ratio between the resin layer (A) and the resin layer (B) was 1:3.8. The subsequent deposition process was carried out as in Example 8.

### (Example 27 and Comparative example 5)

Except that 100 parts by weight of PGA 1 was supplied as the resin composition (1) in the resin layer (A) and that the stretching and heat treatment conditions were set up as shown in Table 3, the same procedure as in Example 26 was carried out to produce a film with a film thickness of 15.0 µm, followed by carrying out a deposition process to produce a vapor deposited film.

### (Examples 28, 29, and 31)

Except that the stretching and heat treatment conditions were set up as shown in Table 3, the same procedure as in Example 26 was carried out to produce a film with a film thickness of 15.0 µm, followed by carrying out a deposition process to produce a vapor deposited film.

### (Example 30)

The biaxially stretched film produced in Example 26 was subjected to the same corona treatment step as described above, and a vapor deposited film was produced using silicon oxide instead as vapor deposition source.

### (Examples 32 and 33)

Except that 100 parts by weight of PLA 2 was supplied as the resin composition (2) in the resin layer (B) and that the stretching and heat treatment conditions were set up as described in Table 3, the same procedure as in Example 26 was carried out to produce a film with a film thickness of 15.0 µm, followed by carrying out a deposition process to produce a vapor deposited film.

### (Example 34)

Except that aluminum was used instead as vapor deposition source, the same procedure as in Example 31 was carried out to produce a vapor deposited film.

### (Example 35)

Except that aluminum was used instead as vapor deposition source, the same procedure as in Example 33 was carried out to produce a vapor deposited film.

Results are shown in Table 3. PLA in Table 3 means polylactic acid.

[Table 3]

**[Table 3]**

| | | Example 26 | Example 27 | Example 28 | Example 29 | Examples 30 | Example 31 | Example 32 | Example 33 | Example 34 | Example 35 | Comparative example 5 | Comparative example 6 |
|---|---|---|---|---|---|---|---|---|---|---|---|---|---|
| Resin layer (A) | Component | PGA 2 | PGA 1 | PGA 2 | PGA 2 | PGA 2 | PGA 2 | PGA 2 | PGA2 | PGA 2 | PGA 2 | PGA 1 | PLA1 |
| | Parts by weight | 100 | 100 | 100 | 100 | 100 | 100 | 100 | 100 | 100 | 100 | 100 | 100 |
| Resin layer (B) | Component | PLA1 | PLA1 | PLA1 | PLA1 | PLA1 | PLA1 | PLA2 | PLA2 | PLA1 | PLA2 | PLA1 | - |
| | Parts by weight | 100 | 100 | 100 | 100 | 100 | 100 | 100 | 100 | 100 | 100 | 100 | - |
| | Tg(°C) | 40 | 40 | 40 | 40 | 40 | 40 | 58 | 58 | 40 | 58 | 40 | - |
| Film layer constitution | | A/B | A/B | A/B | A/B | A/B | A/B | A/B | A/B | A/B | A/B | A/B | monolayer |
| Longitudinal drawing | Temperature | 60 | 70 | 60 | 60 | 60 | 60 | 60 | 60 | 60 | 60 | 85 | 85 |
| | Ratio | 3.0 | 2.1 | 4.5 | 2.5 | 3.0 | 3.0 | 3.0 | 3.0 | 3.0 | 3.0 | 3.5 | 3.5 |
| Transverse drawing | Temperature | 60 | 65 | 60 | 60 | 60 | 50 | 60 | 50 | 50 | 50 | 75 | 75 |
| | Ratio | 3.0 | 2.3 | 4.5 | 2.5 | 3.0 | 3.0 | 3.0 | 3.0 | 3.0 | 3.0 | 3.5 | 3.5 |
| Heat fixation | Temperature | 150 | 150 | 150 | 150 | 150 | 150 | 150 | 150 | 150 | 150 | 150 | 150 |
| Vapor deposited layer | | alumina | alumina | alumina | alumina | silica | alumina | alumina | alumina | aluminum | aluminum | alumina | alumina |
| Center line average roughness | Ra | 15 | 43 | 20 | 23 | 15 | 9 | 14 | 8 | 9 | 9 | 52 | 25 |
| Foreign objects | Number/m² | 0 | 0 | 0 | 0 | 0 | 0 | 0 | 0 | 0 | 0 | 0 | 0 |
| Heart shrinkage degree | MD | 5.3 | 5.1 | 7.6 | 3.2 | 5.3 | 5.3 | 5.6 | 5.3 | 5.3 | 5.3 | 6.5 | 5.3 |
| | TD | 5.6 | 4.8 | 7.3 | 3.8 | 5.6 | 5.9 | 5.9 | 6.1 | 5.9 | 6.1 | 6.1 | 5.1 |
| Tensile modulus | MD | 54 | 5.3 | 6.1 | 3.4 | 5.4 | 5.4 | 5.7 | 5.8 | 5.4 | 5.8 | 6.7 | 3 |
| | TD | 5.3 | 5.2 | 5.9 | 3.3 | 5.3 | 5.2 | 5.5 | 5.7 | 5.2 | 5.7 | 6.7 | 2.8 |
| fn | | 0.0341 | 0.0421 | 0.0413 | 0.0289 | 0.0341 | 0.0337 | 0.0343 | 0.0341 | 0.0337 | 0.0337 | 0.0681 | 0.0122 |
| Oxygen transmittance | cc/(m²·day·atm) | 0.73 | 2.16 | 1.32 | 2.49 | 0.99 | 0.65 | 0.71 | 0.62 | 0.61 | 0.59 | 4.35 | 20.3 |
| Carbon dioxide gas transmittance | cc/(m²·day·atm) | 1.05 | 4.35 | 2.38 | 2.09 | 1.62 | 1.01 | 1.02 | 0.88 | 0.98 | 0.81 | 10.22 | 50.2 |
| Moisture transmittance | g/(m²·day) | 0.91 | 1.73 | 1.22 | 1.53 | 0.98 | 0.45 | 0.57 | 0.39 | 0.41 | 0.35 | 2.85 | 5.54 |

### (Comparative example 6)

As the resin composition (1) in the resin layer (A), 100 parts by weight of PLA 1 was supplied to the single screw extruder 1 and extruded at 230°C, and the polymer was filtered through a filter with an average aperture of 25 µm produced by sintering and compressing stainless steel fiber, and discharged through an orifice. Then, the polymer was wound up on a drum adjusted to a temperature of 25°C to cool and solidify it to form a sheet. Said film was stretched 3.5-fold by rolls at 85°C in the length direction, immediately cooled to room temperature, fed to a tenter, stretched 3.5-fold at 75°C in the width direction, and then, while maintaining a 5% relaxation in the width direction, heat-treated at a temperature of 150°C. A deposition process was carried out as in Example 8 to produce a vapor deposited film.

### (Example 36)

As the resin composition (1) in the resin layer (A), 100 parts by weight of PGA 1 was supplied to the single screw extruder 1 and extruded at 265°C, and the polymer was filtered through a filter with an average aperture of 25 µm produced by sintering and compressing stainless steel fiber. As the resin composition (2) in the resin layer (B), 60 parts by weight of PBT and 40 parts by weight of PET were supplied to the single screw extruder 2 and extruded at 270°C, and the polymer was filtered through a filter with an average aperture of 12 µm produced by sintering and compressing stainless steel fiber. They were discharged through a multi-layered orifice into a two-layer material consisting of the resin layer (A) and the resin layer (B), and wound up on a drum adjusted to a temperature of 25°C to cool and solidify to form a sheet. Said film was stretched 4.0-fold by rolls at 60°C in the length direction, and immediately cooled to room temperature. Then, the resin layer (A) side was corona-treated, and EVOH coating material was prepared and spread over the film, followed by smoothing with a No. 6 bar coater. Subsequently, the film was fed to a tenter, stretched 4.0-fold at 60°C in the width direction, and then, while maintaining a 5% relaxation in the width direction, heat-treated at a temperature of 190°C to provide a biaxially stretched film. The resulting film had a thickness of 15.0 µm, and the thickness ratio between the resin layer (A) and the resin layer (B) was 1:5. The resulting film was subjected to corona discharge treatment at 30 W·min/m² and film temperature of 60°C in an mixed gas atmosphere of nitrogen and carbon dioxide gas (carbon dioxide gas content 15 vol.%), and wound up. The film was fed to a vacuum deposition apparatus equipped with a film traveling mechanism, and after reducing the pressure down to 1.00 × 10⁻² Pa, allowed to travel on a cooled metal drum of 20°C. During this step, aluminum metal was heated to vaporize while supplying oxygen gas to form a thin vapor deposited layer. After the deposition step, the pressure in the vacuum deposition apparatus was increased to atmospheric pressure, and the wound-up film was rewound, followed by aging at a temperature of 40°C for 2 days to provide a vapor deposited film. The optical density of the vapor deposited film was monitored in-line during the deposition step, and controlled at 0.08.

### (Example 37)

Except for using polyurethane coating material as said coating agent, the same film production and vapor deposition procedures as in Example 36 were carried out to produce a vapor deposited film.

### (Example 38)

The biaxially stretched film produced in Example 8 was wound up, and its resin layer (A) side was corona-treated, coated with PAN coating material with a No. 4 coater, and dried at 100°C. The same deposition procedures as in Example 8 was carried out to produce a vapor deposited film.

### (Example 39)

The vapor deposited layer side of the vapor deposited film produced in Example 8 was coated with EVOH coating material with a No. 4 coater, and dried at 100°C to produce a film.

### (Examples 40 and 41)

Except for using PAN or polyurethane coating material as said coating agent, the same procedure as in Example 39 was carried out to produce a film.

### (Example 42)

The vapor deposited layer side of the vapor deposited film produced in Example 37 was coated with PAN coating material with a No. 4 coater, and dried at 100°C to produce a film.

Results are shown in Table 4.

The abbreviations are as described below.
EVOH: ethylene-vinyl alcohol coating material
PAN: polyacrylonitrile coating material
PU: polyurethane coating material

**[Table 4]**

| | | Example 36 | Example 37 | Example 38 | Example 39 | Example 40 | Example 41 | Example 42 |
|---|---|---|---|---|---|---|---|---|
| Resin layer (A) | Component | PGA 1 | PGA 1 | PGA 1 | PGA 1 | PGA 1 | PGA 1 | PGA 1 |
| | Parts by weight | 100 | 100 | 100 | 100 | 100 | 100 | 100 |
| Resin layer (B) | Component | PET/PBT | PET/ PBT | PET/PBT | PET/PBT | PET/PBT | PET/ PBT | PET/ PBT |
| | Parts by weight | 40/60 | 40/60 | 40/60 | 40/60 | 40/60 | 40/60 | 40/60 |
| | Tg (°C) | 38 | 38 | 38 | 38 | 38 | 38 | 38 |
| Film layer constitution | | A/B | A/B | A/B | A/B | A/B | A/B | A/B |
| Longitudinal drawing | Temperature | 60 | 60 | 60 | 60 | 60 | 60 | 60 |
| | Ratio | 4.0 | 4.0 | 4.0 | 4.0 | 4.0 | 4.0 | 4.0 |
| Transverse drawing | Temperature | 60 | 60 | 50 | 50 | 50 | 50 | 60 |
| | Ratio | 4.0 | 4.0 | 4.0 | 4.0 | 4.0 | 4.0 | 4.0 |
| Heat fixation | Temperature | 190 | 190 | 190 | 190 | 190 | 190 | 190 |
| Anchor | Method | in-line | in-line | off-line | - | - | - | in-line |
| coating | Component | EVOH | PU | PAN | - | - | - | PU |
| Overcoating | Method | - | - | - | off-line | off-line | off-line | off-line |
| | Component | - | - | - | EVOH | PU | PAN | PAN |
| Vapor deposited layer | | alumina | alumina | alumina | alumina | alumina | alumina | alumina |
| Center line average roughness | Ra | 13 | 13 | 15 | 15 | 15 | 15 | 13 |
| Foreign objects | Number/m² | 0 | 0 | 0 | 0 | 0 | 0 | 0 |
| Heat shrinkage | MD | 3.2 | 3.2 | 3.0 | 3.0 | 3.0 | 3.0 | 3.2 |
| | TD | 2.5 | 2.5 | 2.5 | 2.5 | 2.5 | 2.5 | 2.5 |
| Tensile modulus | MD | 6.8 | 6.8 | 6.6 | 6.6 | 6.6 | 6.6 | 6.8 |
| | TD | 7.1 | 7.1 | 7.0 | 7.0 | 7.0 | 7.0 | 7.1 |
| fn | | 0.0632 | 0.0632 | 0.0661 | 0.0661 | 0.0661 | 0.0661 | 0.0632 |
| Oxygen transmittance | cc/(m²·day· atm) | 0.20 | 0.23 | 0.19 | 0.19 | 0.20 | 0.17 | 0.09 |
| Carbon dioxide gas transmittance | cc/(m²·day_{·} atm) | 0.38 | 0.37 | 0.16 | 0.18 | 0.36 | 0.17 | 0.08 |

It is seen from Tables 1 to 4 that the vapor deposited film of the invention had high barrier properties. Furthermore, the film of the invention suffered no troubles during the film production and deposition processes, indicating high processing suitability.

### [Industrial applicability]

The invention relates to a vapor deposited film with high gas barrier properties against oxygen, carbon dioxide gas, and moisture, and also relates to a film suitable as material for said vapor deposited film.

## Claims

1. A vapor deposited film comprising at least a resin layer (A) composed of a resin composition (1) wherein a vapor deposited layer of metal or inorganic oxide is provided at least on one side of the resin layer (A), while the resin composition (1) contains a polyglycolic acid component in which a structure as represented by Chemical formula 1 accounts for 70 mol% or more, and the vapor deposited layer side surface of the resin layer (A) has a center line average roughness of 5 nm to 50 nm.

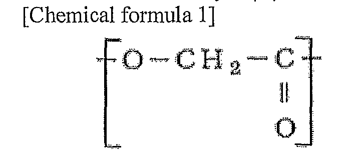

2. A vapor deposited film as specified in Claim 1 additionally comprising a resin layer (B) composed of a resin composition (2) wherein the resin composition (2) has a glass transition temperature of 65°C or less.

3. A vapor deposited film as specified in Claim 2 comprising a resin layer (B), a resin layer (A), and a vapor deposited layer laminated in this order wherein the resin composition (2) contains at least one selected from the following: aromatic polyester, aliphatic polyester, polyolefin, and copolymers thereof.

4. A vapor deposited film as specified in either Claim 2 or 3 wherein the resin composition (2) contains polyethylene terephthalate and polybutylene terephthalate in a polyethylene terephthalate to polybutylene terephthalate ratio by weight of 95/5 to 5/95.

5. A vapor deposited film as specified in any of Claims 1 to 4 that has a degree of heat shrinkage of 8 % or less in the length direction and also a degree of heat shrinkage of 8 % or less in the width direction after heat treatment at 150°C for 30 minutes.
